# EUROPEAN PATENT SPECIFICATION

(11) **EP 3 091 583 B1**
(45) Date of publication and mention of the grant of the patent: **23.09.2020**
(21) Application number: 16168609.2
(22) Date of filing: 06.05.2016
(51) Int. Cl.: H01L 31/0687, H01L 31/0352, H01L 31/054, H01L 31/041

(54) **MULTIJUNCTION INVERTED METAMORPHIC SOLAR CELL**
INVERTIERTE METAMORPHE SOLARZELLE MIT MEHREREN ÜBERGÄNGEN
CELLULE SOLAIRE À MULTIPLES JONCTIONS MÉTAMORPHIQUES INVERSÉES

(30) Priority: 07.05.2015 US 201562158415 P; 17.08.2015 US 201514828197
(43) Date of publication of application: 09.11.2016
(73) Proprietor: SolAero Technologies Corp., Albuquerque, NM 87123 (US)
(72) Inventor: DERKACS, Daniel, Albuquerque, NM 87111 (US); STAN, Mark, Albuquerque, NM 87122 (US)
(74) Representative: adares Patent- und Rechtsanwälte Reininger & Partner GmbB

(56) References cited:
- EP-A1- 2 610 924
- US-A1- 2008 163 920
- US-A1- 2011 180 129
- PATEL P ET AL: "Initial results of the monolithically grown six-junction inverted metamorphic multi-junction solar cell", 2012 IEEE 38TH PHOTOVOLTAIC SPECIALISTS CONFERENCE (PVSC) PART 2, IEEE, 3 June 2012 (2012-06-03), pages 1-4, XP032521141, DOI: 10.1109/PVSC-VOL 2.2013.6656717 [retrieved on 2013-11-05]
- KING R. R. ET AL: "Band-Gap-Engineered Architectures for High-Efficiency Multijunction Concentrator Solar Cells", PROCEEDINGS OF THE 24TH EUROPEAN PHOTOVOLTAIC SOLAR ENERGY CONFERENCE AND EXHIBITION, 21 September 2009 (2009-09-21), - 25 September 2009 (2009-09-25), pages 55-61, XP040529653, Hamburg-GERMANY DOI: 10.4229/24thEUPVSEC2009-1AO.5.2 ISBN: 978-3-936338-25-6
- R Campesato ET AL: "High Efficiency Four Junction Lattice Matched Solar Cells for Space Applications: Analysis of Radiation Hardness Against 1 MeV Electrons", Proceedings of the 29th European Photovoltaic Solar Energy Conference and Exhibition, 25 September 2014 (2014-09-25), XP055548202, Sylvensteinstr. 2 81369 Munich, Germany DOI: 10.4229/EUPVSEC20142014-4DO.13.3 ISBN: 978-3-936338-34-8 Retrieved from the Internet: URL:https://www.eupvsec-proceedings.com/pr oceedings?fulltext=campesato&paper=28152 [retrieved on 2019-01-28]

## Description

### BACKGROUND

### 1. Field

The present disclosure relates to the field of semiconductor devices, and to fabrication processes and devices such as multijunction solar cells based on III-V semiconductor compounds including a metamorphic layer. Such devices are also known as inverted metamorphic multijunction solar cells.

### 2. Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

Typical III-V compound semiconductor solar cells are fabricated on a semiconductor wafer in vertical, multijunction structures. The individual solar cells or wafers are then disposed in horizontal arrays, with the individual solar cells connected together in an electrical series circuit. The shape and structure of an array, as well as the number of cells it contains, are determined in part by the desired output voltage and current.

Inverted metamorphic solar cell structures based on III-V compound semiconductor layers, such as described in M.W. Wanlass et al., Lattice Mismatched Approaches for High Performance, III-V Photovoltaic Energy Converters (Conference Proceedings of the 31st IEEE Photovoltaic Specialists Conference, Jan. 3-7, 2005, IEEE Press, 2005), present an important conceptual starting point for the development of future commercial high efficiency solar cells. However, the materials and structures for a number of different layers of the cell proposed and described in such reference present a number of practical difficulties relating to the appropriate choice of materials and fabrication steps. EP 2 610 924 A1 discloses a multijunction solar cell having four subcells and a graded interlayer. Patel P. et al.: "Initial results of monolithically grown six-junction inverted metamorphic multi-junction solar cell", 2012 IEEE 38th Photovoltaic Specialists Conference (PVSC) Part 2, IEEE, 3.6.2012, pages 1-4, discloses a six-junction lattice mismatched solar cell. King R.R. et al.: "Band-Gap-Engineering Architectures for High-Efficiency Multijunction Concentrator Solar Cells", Proceedings of the 24th European Photovoltaic Solar Energy Conference and Exhibition, 21.9.2009, pages 55-61, evaluates energy loss mechanisms of high-efficiency multijunction cell architectures such as inverted metamorphic 3- and 4-junction cells. It discloses band-gap-engineered lattice-matched and metamorphic 3-junction solar cells, and 4-junction terrestrial concentrator solar cells. US 2008/0163920 A1 discloses a three-junction solar cell with the aim of improving radiation stability in order to increase end of life efficiency. US 2011/180129 A1 discloses a solar cell comprising multiple quantum well (MQW) structures in an intrinsic region of monolithic photovoltaic junctions within them. The structures may be lattice matched to GaAs or Ge. Campesato R. et al.: "High Efficiency Four Junction Lattice Matched Solar Cells for Space Applications: Analysis of Radiation Hardness Against 1 MeV Electrons", Proceedings of the 29th European Photovoltaic Solar Energy Conference and Exhibition, 25.9.2014, discloses a four junction lattice matched solar cell and analyses its radiation hardness.

Improving the efficiency of space-grade solar cells has been the goal of researchers for decades. Efficiency of space-grade solar cells has improved from 23% (for a dual-junction InGaP/GaAs on inactive Ge) to 29.5% (for a triple-junction InGaP/InGaAs/Ge solar cell), which not only been realized through improved material quality, but also through improved cell designs that reduce power degradation from charged particle radiation that is characteristic of the space operating environment.

### SUMMARY

The subject-matter of the present invention is defined in independent claim 1 (product) and independent claim 8 (method). According to the invention, the four-junction inverted metamorphic solar cell comprises: an upper first solar subcell having a first band gap; a second solar subcell adjacent to said upper first solar subcell and having a second band gap smaller than said first band gap; a third solar subcell adjacent to said second solar subcell and having a third band gap smaller than said second band gap; a graded interlayer adjacent to said third solar subcell, said graded interlayer having a fourth band gap greater than said third band gap; and a lower fourth solar subcell adjacent to said graded interlayer, said lower fourth solar subcell having a fifth band gap smaller than said third band gap such that said lower fourth solar subcell is lattice mismatched with respect to said third solar subcell.

According to the invention, the method comprises: providing a first substrate; depositing on the first substrate a first sequence of layers of semiconductor material forming a first solar subcell, a second solar subcell, and a third solar subcell; depositing on said third solar subcell a grading interlayer; depositing on said grading interlayer a second sequence of layers of semiconductor material forming a fourth solar subcell, the fourth solar subcell being lattice mismatched to the third solar subcell; mounting and bonding a surrogate substrate on top of the sequence of layers; and removing the first substrate.

The graded interlayer is compositionally graded to lattice match the third solar subcell on one side and the fourth solar subcell on the other side.

The graded interlayer is composed of (InₓGa₁₋ₓ)_{y}Al_{1-y}As with 0 < x < 1, 0 < y < 1, and x and y selected such that the band gap remains constant throughout its thickness.

The band gap of the graded interlayer has a value in the range of 1.42 to 1.60 eV throughout its thickness.

The upper first subcell is composed of an AlInGaP or InGaP emitter layer and an AlInGaP base layer, the second subcell is composed of an InGaP emitter layer and a AlGaAs base layer, the third subcell is composed of GaAs or InₓGa₁₋ₓAs with 0 < x < 0.01 and the bottom fourth subcell is composed of InGaAs.

The fourth solar subcell has a band gap of approximately 1.10 eV, the third solar subcell has a band gap in the range of 1.40 - 1.42 eV, the second solar subcell has a band gap of approximately 1.73 eV and the first solar subcell has a band gap of approximately 2.10 eV.

Each of the second subcell and the upper first subcell comprise aluminum in addition to semiconductor elements.

Each of the second subcell and the upper first subcell comprise aluminum in such quantity so that the average band gap of all four subcells is greater than 1.44 eV.

The selection of the composition of the subcells and their band gaps maximizes the efficiency of the solar cell at a predetermined high temperature value (in the range of 50 to 70 degrees Centigrade) in deployment in space at AM0 at a predetermined time after the beginning of life (BOL), such predetermined time being referred to as the end-of-life (EOL) time.

The predetermined time is at least two years, five years, ten years, or at least fifteen years.

The selection of the composition of the subcells and their band gaps maximizes the efficiency of the solar cell at a predetermined high temperature value (in the range of 50 to 70 degrees Centigrade) not at initial deployment, but after continuous deployment of the solar cell in space at AM0 at a predetermined time after the initial deployment, such time being at least x years, where x is in the range of 1 to 20, with the average band gap of all four cells being greater than 1.44 eV.

In some embodiments, additional layer(s) may be added or deleted in the cell structure without departing from the scope of the claims.

### BRIEF DESCRIPTION OF THE DRAWING

The apparatus and methods described herein will be better and more fully appreciated by reference to the following detailed description when considered in conjunction with the accompanying drawings, wherein:
FIG. 1 is a cross-sectional view of a solar cell after an initial stage of fabrication including the deposition of certain semiconductor layers on the growth substrate;
FIG. 2A is a cross-sectional view of a first embodiment of the solar cell of FIG. 1 that includes one distributed Bragg reflector (DBR) layer after the next sequence of process steps;
FIG. 2B is a cross-sectional view of a second embodiment of the solar cell of FIG. 1 that includes one distributed Bragg reflector (DBR) layer after the next sequence of process steps;
FIG. 3A is a cross-sectional view of a first embodiment of the solar cell of FIG. 1 that includes two distributed Bragg reflector (DBR) layers after the next sequence of process steps; and
FIG. 3B is a cross-sectional view of a second embodiment of the solar cell of FIG. 1 that includes two distributed Bragg reflector (DBR) layers after the next sequence of process steps.

### GLOSSARY OF TERMS

"End of Life (EOL)" refers to a predetermined time or times after the Beginning of Life, during which the photovoltaic power system has been deployed and has been operational. The EOL time or times may, for example, be specified by the customer as part of the required technical performance specifications of the photovoltaic power system to allow the solar cell designer to define the solar cell subcells and sublayer compositions of the solar cell to meet the technical performance requirement at the specified time or times, in addition to other design objectives. The terminology "EOL" is not meant to suggest that the photovoltaic power system is not operational or does not produce power after the EOL time.

"ZTJ" refers to the product designation of a commercially available SolAero Technologies Corp. triple junction solar cell.

### DESCRIPTION OF THE PREFERRED EMBODIMENTS

Details of the present disclosure will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A 33% efficient quadruple-junction InGaP₂/GaAs/In_{0.30}Ga_{0.70}As/In_{0.60}Ga_{0.40}As (with band gaps 1.91 eV / 1.42 eV / 1.03 eV / 0.70 eV, respectively) inverted metamorphic multijunction cell may be 10% (relative) more efficient at beginning of life (BOL) than standard ZTJ triple-junction devices and have 40% lower mass when permanently bonded to a 150 um thick low-mass rigid substrate. Further, inverted metamorphic technology may extend the choice of materials that can be integrated together by making possible simultaneous realization of high quality materials that are both lattice-matched to the substrate (InGaP and GaAs, grown first) and lattice-mismatched (In_{0.30}Ga_{0.70}As and In_{0.60}Ga_{0.40}As). The advantage of a metamorphic approach may be that a wide range of infrared bandgaps may be accessed via InGaAs subcells grown atop optically transparent step graded buffer layers. Further, metamorphic materials may offer near-perfect quantum efficiencies, favorably low E_{g} - V_{oc} offsets, and high efficiencies. As may often be the case though, efficiency gains may rarely materialize without additional costs. For example, a quadruple-junction inverted metamorphic multijunction cell may be more costly than a ZTJ due to thicker epitaxy and more complicated processing. Further, an inverted epitaxial foil may be removed from the growth substrate and temporarily or permanently bonded to a rigid substrate right-side-up to complete frontside processing. Still further, the result may be an all-top-contact cell that may be largely indistinguishable from a traditional ZTJ solar cell. Yet despite the quadruple-junction inverted metamorphic multijunction cell being a higher efficiency, lower mass drop-in replacement for ZTJ, the higher specific cost [$/Watt] may discourage customers from adopting new or changing cell technologies.

The inverted metamorphic quadruple-junction AlInGaP/AlGaAs/GaAs/InGaAs (with band gaps 2.1 eV / 1.73 eV / 1.42 eV / 1.10 eV respectively) solar cell, according to the present disclosure, is not a design that agrees with the conventional wisdom in that an optimized multijunction cell should have balanced photocurrent generation among all subcells and use the entire solar spectrum including the infrared spectrum from 1200 nm - 2000 nm. In this disclosure, a high bandgap current-matched triple-junction stack may be grown first followed by a lattice-mismatched 1.10 eV InGaAs subcell, which in one embodiment, forms the "bottom" subcell. The inverted InGaAs subcell is subsequently removed from the growth substrate and bonded to a rigid carrier so that the four junction solar cell can then be processed as a normal solar cell.

Despite the beginning of life (BOL) efficiency being lower than the traditional inverted metamorphic quadruple-junction solar cell, when high temperature end of life (hereinafter referred to as "HT-EOL") $/W is used as the design metric, the proposed structure may provide a 10% increase in HT-EOL power and a significant decrease in HT-EOL $/W.

The proposed technology differs from existing art (e.g., U.S. Pat. No. 8,969,712) in that a four junction device is constructed using three lattice-matched subcells and one lattice-mismatched subcell. Previous inverted metamorphic quadruple-junction solar cells devices were constructed using two lattice-matched subcells and two lattice mismatched subcells. As a result, the cost of the epitaxy of the proposed architecture may be cheaper as the cell, e.g., may use a thinner top cell reducing In and P usage, may reduce the number of graded buffer layers to one from two, and may eliminate the need for a high In content bottom cell, which may be expensive due to the quantity of In required.

The basic concept of fabricating an inverted metamorphic multijunction (IMM) solar cell is to grow the subcells of the solar cell on a substrate in a "reverse" sequence. That is, the high band gap subcells (i.e. subcells with band gaps in the range of 1.9 to 2.3 eV), which would normally be the "top" subcells facing the solar radiation, are grown epitaxially on a semiconductor growth substrate, such as for example GaAs or Ge, and such subcells are therefore lattice-matched to such substrate. One or more lower band gap middle subcells (i.e. with band gaps in the range of 1.3 to 1.9 eV) can then be grown on the high band gap subcells.

At least one lower subcell is formed over the middle subcell such that the at least one lower subcell is substantially lattice-mismatched with respect to the growth substrate and such that the at least one lower subcell has a third lower band gap (e.g., a band gap in the range of 0.8 to 1.2 eV). A surrogate substrate or support structure is then attached or provided over the "bottom" or substantially lattice-mismatched lower subcell, and the growth semiconductor substrate is subsequently removed. (The growth substrate may then subsequently be re-used for the growth of a second and subsequent solar cells).

A variety of different features of inverted metamorphic multijunction solar cells disclosed in the related applications of Applicant may be included in the structures and processes associated with the solar cells of the present disclosure. However, more particularly, the present disclosure is directed to the fabrication of a four junction inverted metamorphic solar cell using one metamorphic layer, grown on a single growth substrate. In the present disclosure, the resulting construction includes four subcells, with band gaps in the range of 1.92 to 2.2 eV (e.g., 2.10 eV), 1.65 to 1.78 eV (e.g., 1.73 eV), 1.42 to 1.50 eV (e.g., 1.42 eV), and 1.05 to 1.15 eV (e.g., 1.10 eV), respectively.

The lattice constants and electrical properties of the layers in the semiconductor structure are preferably controlled by specification of appropriate reactor growth temperatures and times, and by use of appropriate chemical composition and dopants. The use of a vapor deposition method, such as Organo Metallic Vapor Phase Epitaxy (OMVPE), Metal Organic Chemical Vapor Deposition (MOCVD), Molecular Beam Epitaxy (MBE), or other vapor deposition methods for the reverse growth may enable the layers in the monolithic semiconductor structure forming the solar cell to be grown with the required thickness, elemental composition, dopant concentration and grading and conductivity type.

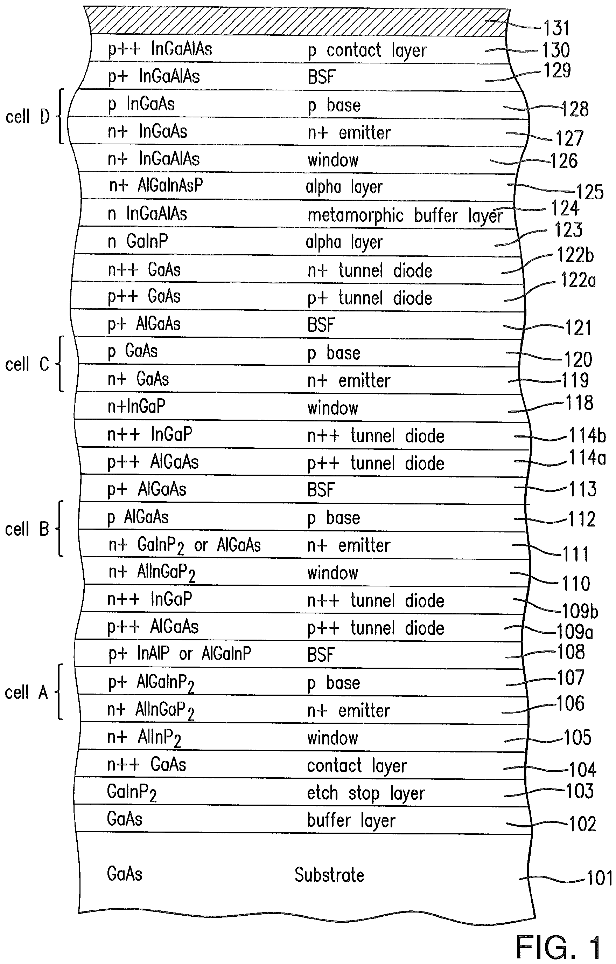

FIG. 1 depicts the multijunction solar cell according to the present disclosure after the sequential formation of the four subcells A, B, C and D on a GaAs growth substrate. More particularly, there is shown a growth substrate 101, which is preferably gallium arsenide (GaAs), but may also be germanium (Ge) or other suitable material. For GaAs, the substrate is preferably a 15° off-cut substrate, that is to say, its surface is orientated 15° off the (100) plane towards the (111)A plane, as more fully described in U.S. Patent Application Pub. No. 2009/0229662 A1 (Stan et al.).

In the case of a Ge substrate, a nucleation layer (not shown) is deposited directly on the substrate 101. On the substrate, or over the nucleation layer (in the case of a Ge substrate), a buffer layer 102 and an etch stop layer 103 are further deposited. In the case of GaAs substrate, the buffer layer 102 is preferably GaAs. In the case of Ge substrate, the buffer layer 102 is preferably InGaAs. A contact layer 104 of GaAs is then deposited on layer 103, and a window layer 105 of AlInP is deposited on the contact layer. The subcell A, consisting of an n+ emitter layer 106 and a p-type base layer 107, is then epitaxially deposited on the window layer 105. The subcell A is generally latticed matched to the growth substrate 101.

It should be noted that the multijunction solar cell structure could be formed by any suitable combination of group III to V elements listed in the periodic table subject to lattice constant and bandgap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In one embodiment, the emitter layer 106 is composed of InGa(Al)P₂ and the base layer 107 is composed of InGa(Al)P₂. The aluminum or Al term in parenthesis in the preceding formula means that Al is an optional constituent, and in this instance may be used in an amount ranging from 0% to 40%.

Subcell A will ultimately become the "top" subcell of the inverted metamorphic structure after completion of the process steps according to the present disclosure to be described hereinafter.

On top of the base layer 107 a back surface field ("BSF") layer 108 preferably p+ AlGaInP is deposited and used to reduce recombination loss.

The BSF layer 108 drives minority carriers from the region near the base/BSF interface surface to minimize the effect of recombination loss. In other words, a BSF layer 108 reduces recombination loss at the backside of the solar subcell A and thereby reduces the recombination in the base.

On top of the BSF layer 108 is deposited a sequence of heavily doped p-type and n-type layers 109a and 109b that forms a tunnel diode, i.e., an ohmic circuit element that connects subcell A to subcell B. Layer 109a is preferably composed of p++ AlGaAs, and layer 109b is preferably composed of n++ InGaP.

A window layer 110 is deposited on top of the tunnel diode layers 109a/109b, and is preferably n+ InGaP. The advantage of utilizing InGaP as the material constituent of the window layer 110 is that it has an index of refraction that closely matches the adjacent emitter layer 111, as more fully described in U.S. Patent Application Pub. No. 2009/0272430 A1 (Comfeld et al.). The window layer 110 used in the subcell B also operates to reduce the interface recombination loss. It should be apparent to one skilled in the art, that additional layer(s) may be added or deleted in the cell structure without departing from the scope of the claims.

On top of the window layer 110 the layers of subcell B are deposited: the n-type emitter layer 111 and the p-type base layer 112. These layers are preferably composed of InGaP and AlInGaAs respectively (for a Ge substrate or growth template), or InGaP and AlGaAs respectively (for a GaAs substrate), although any other suitable materials consistent with lattice constant and bandgap requirements may be used as well. Thus, subcell B may be composed of a GaAs, InGaP, AlGaInAs, AlGaAsSb, GaInAsP, or AlGaInAsP, emitter region and a GaAs, InGaP, AlGaInAs, AlGaAsSb, GaInAsP, or AlGaInAsP base region.

In previously disclosed implementations of an inverted metamorphic solar cell, the second subcell or subcell B or was a homostructure. In the present disclosure, similarly to the structure disclosed in U.S. Patent Application Pub. No. 2009/0078310 A1 (Stan et al.), the second subcell or subcell B becomes a heterostructure with an InGaP emitter and its window is converted from InAlP to AlInGaP. This modification reduces the refractive index discontinuity at the window/emitter interface of the second subcell, as more fully described in U.S. Patent Application Pub. No. 2009/0272430 A1 (Cornfeld et al.). Moreover, the window layer 110 is preferably is doped three times that of the emitter 111 to move the Fermi level up closer to the conduction band and therefore create band bending at the window/emitter interface which results in constraining the minority carriers to the emitter layer.

On top of the cell B is deposited a BSF layer 113 which performs the same function as the BSF layer 109. The p++/n++ tunnel diode layers 114a and 114b respectively are deposited over the BSF layer 113, similar to the layers 109a and 109b, forming an ohmic circuit element to connect subcell B to subcell C. The layer 114a is preferably composed of p++ AlGaAs, and layer 114b is preferably composed of n++ InGaP.

A window layer 118 preferably composed of n+ type GaInP is then deposited over the tunnel diode layer 114. This window layer operates to reduce the recombination loss in subcell "C". It should be apparent to one skilled in the art that additional layers may be added or deleted in the cell structure without departing from the scope of the claims.

On top of the window layer 118, the layers of cell C are deposited: the n+ emitter layer 119, and the p-type base layer 120. These layers are preferably composed of n+ type GaAs and n+ type GaAs respectively, or n+ type InGaP and p type GaAs for a heterojunction subcell, although another suitable materials consistent with lattice constant and bandgap requirements may be used as well.

In some embodiments, subcell C may be (In)GaAs with a band gap between 1.40 eV and 1.42 eV. Grown in this manner, the cell has the same lattice constant as GaAs but has a low percentage of Indium 0% < In < 1% to slightly lower the band gap of the subcell without causing it to relax and create dislocations. In this case, the subcell remains lattice matched, albeit strained, and has a lower band gap than GaAs. This helps improve the subcell short circuit current slightly and improve the efficiency of the overall solar cell.

In some embodiments, the third subcell or subcell C may have quantum wells or quantum dots that effectively lower the band gap of the subcell to approximately 1.3 eV. All other band gap ranges of the other subcells described above remain the same. In such embodiment, the third subcell is still lattice matched to the GaAs substrate. Quantum wells are typically "strain balanced" by incorporating lower band gap or larger lattice constant InGaAs (e.g. a band gap of ∼1.3 eV) and higher band gap or smaller lattice constant GaAsP. The alternating larger/smaller atomic lattices/layers of epitaxy balance the strain and keep the material lattice matched.

A BSF layer 121, preferably composed of InGaAlAs, is then deposited on top of the cell C, the BSF layer performing the same function as the BSF layers 108 and 113.

The p++/n++ tunnel diode layers 122a and 122b respectively are deposited over the BSF layer 121, similar to the layers 114a and 114b, forming an ohmic circuit element to connect subcell C to subcell D. The layer 122a is preferably composed of p++ GaAs, and layer 122b is preferably composed of n++ GaAs.

An alpha layer 123, preferably composed of n-type GaInP, is deposited over the tunnel diode 122a/122b, to a thickness of about 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Cornfeld et al.).

A metamorphic layer (or graded interlayer) 124 is deposited over the alpha layer 123 using a surfactant. Layer 124 is preferably a compositionally step-graded series of InGaAlAs layers, preferably with monotonically changing lattice constant, so as to achieve a gradual transition in lattice constant in the semiconductor structure from subcell C to subcell D while minimizing threading dislocations from occurring. The band gap of layer 124 is constant throughout its thickness, preferably approximately equal to 1.5 to 1.6 eV, or otherwise consistent with a value slightly greater than the band gap of the middle subcell C. One embodiment of the graded interlayer may also be expressed as being composed of (InₓGa₁₋ₓ)_{y} Al_{1-y}As, with x and y selected such that the band gap of the interlayer remains constant at approximately 1.5 to 1.6 eV or other appropriate band gap.

In the surfactant assisted growth of the metamorphic layer 124, a suitable chemical element is introduced into the reactor during the growth of layer 124 to improve the surface characteristics of the layer. In the preferred embodiment, such element may be a dopant or donor atom such as selenium (Se) or tellurium (Te). Small amounts of Se or Te are therefore incorporated in the metamorphic layer 124, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 124.

In the inverted metamorphic structure described in the Wanlass et al. paper cited above, the metamorphic layer consists of nine compositionally graded InGaP steps, with each step layer having a thickness of 0.25 micron. As a result, each layer of Wanlass et al. has a different bandgap. In the preferred embodiment of the present disclosure, the layer 124 is composed of a plurality of layers of InGaAlAs, with monotonically changing lattice constant, each layer having the same band gap, approximately 1.5 eV.

The advantage of utilizing a constant bandgap material such as InGaAlAs is that arsenide-based semiconductor material is much easier to process in standard commercial MOCVD reactors, while the small amount of aluminum assures radiation transparency of the metamorphic layers.

Although the preferred embodiment of the present disclosure utilizes a plurality of layers of InGaAlAs for the metamorphic layer 124 for reasons of manufacturability and radiation transparency, other embodiments of the present disclosure may utilize different material systems to achieve a change in lattice constant from subcell C to subcell D. Thus, the system of Wanlass using compositionally graded InGaP is a second embodiment of the present disclosure. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the second solar cell and less than or equal to that of the third solar cell, and having a bandgap energy greater than that of the second solar cell.

An alpha layer 125, preferably composed of n+ type AlGaInAsP, is deposited over metamorphic buffer layer 124, to a thickness of about 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Comfeld et al.).

A window layer 126 preferably composed of n+ type InGaAlAs is then deposited over alpha layer 125. This window layer operates to reduce the recombination loss in the fourth subcell "D". It should be apparent to one skilled in the art that additional layers may be added or deleted in the cell structure without departing from the scope of the claims.

On top of the window layer 126, the layers of cell D are deposited: the n+ emitter layer 127, and the p-type base layer 128. These layers are preferably composed of n+ type InGaAs and p type InGaAs respectively, or n+ type InGaP and p type InGaAs for a heterojunction subcell, although another suitable materials consistent with lattice constant and bandgap requirements may be used as well.

A BSF layer 129, preferably composed of p+ type InGaAlAs, is then deposited on top of the cell D, the BSF layer performing the same function as the BSF layers 108, 113 and 121.

A high band gap contact layer 130, preferably composed of p++ type InGaAlAs, is deposited on the BSF layer 129.

The composition of this contact layer 130 located at the bottom (non-illuminated) side of the lowest band gap photovoltaic cell (i.e., subcell "D" in the depicted embodiment) in a multijunction photovoltaic cell, can be formulated to reduce absorption of the light that passes through the cell, so that (i) the backside ohmic metal contact layer below it (on the non-illuminated side) will also act as a mirror layer, and (ii) the contact layer doesn't have to be selectively etched off, to prevent absorption.

A metal contact layer 131 is deposited over the p semiconductor contact layer 130. The metal is preferably the sequence of metal layers Ti/Au/Ag/Au.

Also, the metal contact scheme chosen is one that has a planar interface with the semiconductor, after heat treatment to activate the ohmic contact. This is done so that (1) a dielectric layer separating the metal from the semiconductor doesn't have to be deposited and selectively etched in the metal contact areas; and (2) the contact layer is specularly reflective over the wavelength range of interest.

Optionally, an adhesive layer (e.g., Wafer Bond, manufactured by Brewer Science, Inc. of Rolla, MO) can be deposited over the metal layer 131, and a support or surrogate substrate can be attached. In some embodiments, the surrogate substrate may be sapphire. In other embodiments, the surrogate substrate may be GaAs, Ge or Si, or other suitable material. The surrogate substrate can be about 40 mils in thickness, and can be perforated with holes about 1 mm in diameter, spaced 4 mm apart, to aid in subsequent removal of the adhesive and the substrate. As an alternative to using an adhesive layer, a suitable substrate (e.g., GaAs) may be eutectically or permanently bonded to the metal layer 131.

Optionally, the original substrate can be removed by a sequence of lapping and/or etching steps in which the substrate 101, and the buffer layer 102 are removed. The choice of a particular etchant is growth substrate dependent.

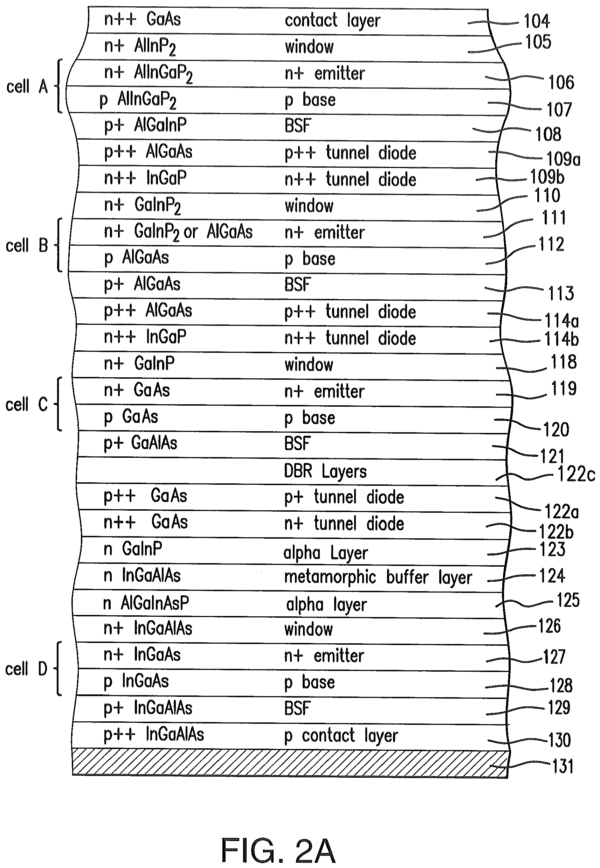

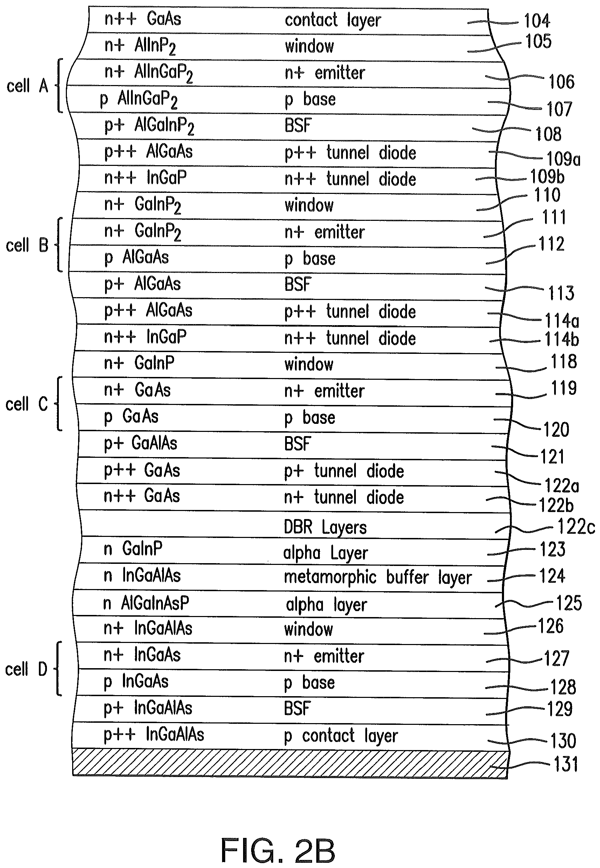

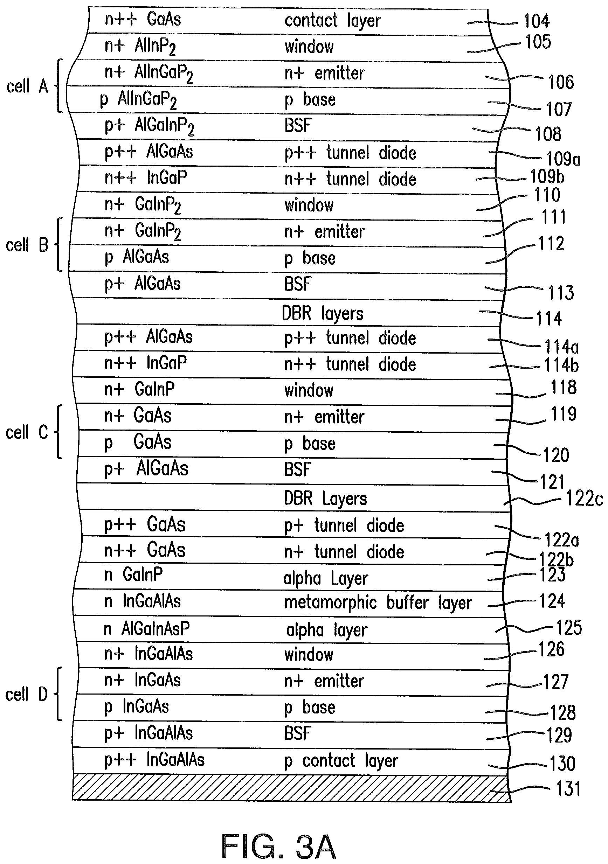

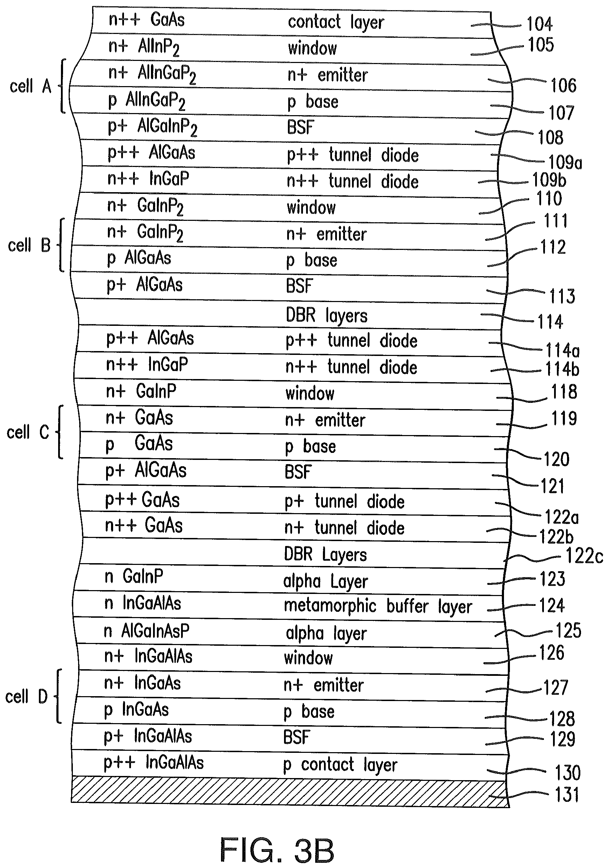

Figures 2A, 2B, 3A, and 3B are cross-sectional views of embodiments of solar cells similar to that in FIG. 1, with the orientation with the metal contact layer 131 being at the bottom of the Figure and with the original substrate having been removed. In addition, the etch stop layer 103 has been removed, for example, by using a HCl/H₂O solution.

It should be apparent to one skilled in the art, that additional layer(s) may be added or deleted in the cell structure without departing from the scope of the claims. For example, one or more distributed Bragg reflector (DBR) layers can be added for various embodiments of the present invention.

Figures 2A and 2B are cross-sectional views of embodiments of a solar cell similar to that of FIG. 1 that includes distributed Bragg reflector (DBR) layers 122c.

FIG. 2A is a cross-sectional view of a first embodiment of a solar cell similar to that of FIG. 1 that includes distributed Bragg reflector (DBR) layers 122c adjacent to and between the third solar subcell C and the graded interlayer 124 and arranged so that light can enter and pass through the third solar subcell C and at least a portion of which can be reflected back into the third solar subcell C by the DBR layers 122c. In FIG. 2A, the distributed Bragg reflector (DBR) layers 122c are specifically located between the third solar subcell C and tunnel diode layers 122a/122b.

FIG. 2B is a cross-sectional view of a second embodiment of a solar cell similar to that of FIG. 1 that includes distributed Bragg reflector (DBR) layers 122c adjacent to and between the third solar subcell C and the graded interlayer 124 and arranged so that light can enter and pass through the third solar subcell C and at least a portion of which can be reflected back into the third solar subcell C by the DBR layers 122c. In FIG. 2B, the distributed Bragg reflector (DBR) layers 122c are specifically located between tunnel diode layers 122a/122b and graded interlayer 124.

Figures 3A and 3B are cross-sectional views of embodiments of a solar cell similar to that of FIG. 1 that include distributed Bragg reflector (DBR) layers 114 in addition to the distributed Bragg reflector layers 122c described in Figures 2A and 2B.

FIG. 3A is a cross-sectional view of a first embodiment of a solar cell similar to that of FIG. 1 that includes, in addition to the distributed Bragg reflector layers 122c described in Figures 2A and 2B, distributed Bragg reflector (DBR) layers 114 adjacent to and between the second solar subcell B and the third solar subcell C and arranged so that light can enter and pass through the second solar subcell B and at least a portion of which can be reflected back into the second solar subcell B by the DBR layers 114. In FIG. 3A, the distributed Bragg reflector (DBR) layers 114 are specifically located between the second solar subcell and tunnel diode layers 114a/114b; and the distributed Bragg reflector (DBR) layers 122c are specifically located between the third solar subcell C and tunnel diode layers 122a/122b.

FIG. 3B is a cross-sectional view of a second embodiment of a solar cell similar to that of FIG. 1 that includes , in addition to the distributed Bragg reflector layers 122c described in Figures 2A and 2B, distributed Bragg reflector (DBR) layers 114 adjacent to and between the second solar subcell B and the third solar subcell C and arranged so that light can enter and pass through the second solar subcell B and at least a portion of which can be reflected back into the second solar subcell B by the DBR layers 114. In FIG. 3B, the distributed Bragg reflector (DBR) layers 114 are specifically located between the second solar subcell and tunnel diode layers 114a/114b; and the distributed Bragg reflector (DBR) layers 122c are specifically located between tunnel diode layers 122a/122b and graded interlayer 124.

For some embodiments, distributed Bragg reflector (DBR) layers 114 and/or 122c can be composed of a plurality of alternating layers of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 114 and/or 122c includes a first DBR layer composed of a plurality of p type AlₓGa₁₋ₓAs layers, and a second DBR layer disposed over the first DBR layer and composed of a plurality of p type Al_{y}Ga_{1-y}As layers, where y is greater than x, and 0 < x < 1, 0 < y < 1.

The present disclosure provides an inverted metamorphic multijunction solar cell that follows a design rule that one should incorporate as many high bandgap subcells as possible to achieve the goal to increase high temperature EOL performance. For example, high bandgap subcells may retain a greater percentage of cell voltage as temperature increases, thereby offering lower power loss as temperature increases. As a result, both HT-BOL and HT-EOL performance of the exemplary inverted metamorphic multijunction solar cell may be expected to be greater than traditional cells.

For example, the cell efficiency (%) measured at room temperature (RT) 28° C and high temperature (HT) 70° C, at beginning of life (BOL) and end of life (EOL), for a standard three junction commercial solar cell (ZTJ) is as follows:

| **Condition** | **Efficiency** | |
|---|---|---|
| BOL 28° C | 29.1% | |
| BOL 70° C | 26.4% | |
| EOL 70° C | 23.4% | After 5E14 e/cm² radiation |
| EOL 70° C | 22.0% | After 1E15 e/cm² radiation |

For the IMMX solar cell described in the present disclosure, the corresponding data is as follows:

| **Condition** | **Efficiency** | |
|---|---|---|
| BOL 28° C | 29.5% | |
| BOL 70° C | 26.6% | |
| EOL 70° C | 24.7% | After 5E14 e/cm² radiation |
| EOL 70° C | 24.2% | After 1E15 e/cm² radiation |

One should note the slightly higher cell efficiency of the IMMX solar cell than the standard commercial solar cell (ZTJ) at BOL both at 28° C and 70° C. However, the IMMX solar cell described in the present disclosure exhibits substantially improved cell efficiency (%) over the standard commercial solar cell (ZTJ) at 1 MeV electron equivalent fluence of 5 x 10¹⁴ e/cm², and dramatically improved cell efficiency (%) over the standard commercial solar cell (ZTJ) at 1 MeV electron equivalent fluence of 1 x 10¹⁵ e/cm².

A low earth orbit (LEO) satellite will typically experience radiation equivalent to 5 x 10¹⁴ e/cm² over a five year lifetime. A geosynchronous earth orbit (GEO) satellite will typically experience radiation in the range of 5 x 10¹⁴ e/cm² to 1 x 10 e/cm² over a fifteen year lifetime.

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al. [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalised energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different coverglass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

The software package Spenvis (www.spenvis.oma.be) is used to calculate the specific electron and proton fluence that a solar cell is exposed to during a specific satellite mission as defined by the duration, altitude, azimuth, etc. Spenvis employs the EQFLUX program, developed by the Jet Propulsion Laboratory (JPL) to calculate 1 MeV and 10 MeV damage equivalent electron and proton fluences, respectively, for exposure to the fluences predicted by the trapped radiation and solar proton models for a specified mission environment duration. The conversion to damage equivalent fluences is based on the relative damage coefficients determined for multijunction cells [Marvin, D.C., Assessment of Multijunction Solar Cell Performance in Radiation Environments, Aerospace Report No. TOR-2000 (1210)-1, 2000]. New cell structures eventually need new RDC measurements as different materials can be more or less damage resistant than materials used in conventional solar cells. A widely accepted total mission equivalent fluence for a geosynchronous satellite mission of 15 year duration is 1MeV 1x10¹⁵ electrons/cm².

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g} - V_{oc} metric. In short, increased BOL E_{g} - V_{oc} may be the most problematic shortcoming of aluminum containing subcells; the other limitations can be mitigated by modifying the doping schedule or thinning base thicknesses.

Furthermore, at BOL, it is widely accepted that great subcells have a room temperature E_{g} - V_{oc} of approximately 0.40. A wide variation in BOL E_{g} - V_{oc} may exist for subcells of interest to IMMX cells. However, Applicants have found that inspecting E_{g} - V_{oc} at HT-EOL may reveal that aluminum containing subcells perform no worse than other materials used in III-V solar cells. For example, all of the subcells at EOL, regardless of aluminum concentration or degree of lattice-mismatch, have been shown to display a nearly-fixed E_{g} - V_{oc} of approximately 0.6 at room temperature 28° C.

The exemplary inverted metamorphic multijunction solar cell design philosophy may be described as opposing conventional cell efficiency improvement paths that employ infrared subcells that increase in expense as the bandgap of the materials decreases. For example, proper current matching among all subcells that span the entire solar spectrum is often a normal design goal. Further, known approaches - including dilute nitrides grown by MBE, upright metamorphic, and inverted metamorphic multijunction solar cell designs - may add significant cost to the cell and only marginally improve HT-EOL performance. Still further, lower HT-EOL $/W may be achieved when inexpensive high bandgap subcells are incorporated into the cell architecture, rather than more expensive infrared subcells. The key to enabling the exemplary solar cell design philosophy described herein is the observation that aluminum containing subcells perform well at HT-EOL.

## Claims

1. A four-junction inverted metamorphic solar cell comprising:
an upper first solar subcell (A) having a first band gap, wherein the upper first solar subcell (A) is composed of an AlInGaP or InGaP emitter layer (106) and an AlInGaP base layer (107);
a second solar subcell (B) adjacent to said upper first solar subcell (A) and having a second band gap smaller than said first band gap, wherein the second subcell (B) is composed of an InGaP emitter layer (111) and an AlGaAs base layer (112);
a third solar subcell (C) adjacent to said second solar subcell (B) and having a third band gap smaller than said second band gap, wherein the third solar subcell (C) is composed of GaAs or InₓGa₁₋ₓAs with 0 < x < 0.01;
a graded interlayer (124) adjacent to said third solar subcell (C), said graded interlayer (124) having a fourth band gap greater than said third band gap; and
a lower fourth solar subcell (D) adjacent to said graded interlayer (124), said lower fourth solar subcell (D) having a fifth band gap smaller than said third band gap such that said lower fourth solar subcell (D) is lattice mismatched with respect to said third solar subcell, wherein the bottom fourth subcell (D) is composed of InGaAs;
wherein the graded interlayer (124) is compositionally graded to lattice match the third solar subcell (C) on one side and the lower fourth solar subcell (D) on the other side, and is composed of (InₓGa₁₋ₓ)_{y}Al_{1-y}As with 0 < x < 1, 0 < y < 1, and x and y selected such that the band gap remains constant at a value in a range of 1.42 - 1.6 eV throughout its thickness, subject to the constraints of having the in-plane lattice parameter greater than or equal to that of the third solar subcell (C) and less than or equal to that of the lower fourth solar subcell (D);
wherein the lower fourth solar subcell (D) has a band gap of approximately 1.10 eV, the third solar subcell (C) has a band gap in the range of 1.40 to 1.42 eV, the second solar subcell (B) has a band gap of approximately 1.73 eV and the upper first solar subcell (A) has a band gap of approximately 2.10 eV.

2. The four-junction solar cell as defined in claim 1, further comprising an alpha layer (123) composed of GaInP adjacent to the graded interlayer (124) for preventing threading dislocations from propagating, either opposite to the direction of growth into the first (A), second (B) or third subcells (C), or in the direction of growth into the fourth subcell (D).

3. The four-junction solar cell as defined in any of the preceding claims, further comprising:
a distributed Bragg reflector layer (114) adjacent to and between the second (B) and third (C) solar subcells and arranged so that light can enter and pass through the second solar subcell (B) and at least a portion of which can be reflected back into the second solar subcell (B) by the distributed Bragg reflector layer (114).

4. The four-junction solar cell as defined in any of the preceding claims, further comprising:
a distributed Bragg reflector layer (122c) adjacent to and between the third solar subcell (C) and the graded interlayer (124) and arranged so that light can enter and pass through the third solar subcell (C) and at least a portion of which can be reflected back into the third solar subcell (C) by the distributed Bragg reflector layer (122c).

5. The four-junction solar cell as defined in claim 4, wherein the distributed Bragg reflector layer (122c) is composed of a plurality of alternating layers of lattice matched materials with discontinuities in their respective indices of refraction, and the difference in refractive indices between alternating layers is maximized in order to minimize the number of periods required to achieve a given reflectivity, and the thickness and refractive index of each period determines the stop band and its limiting wavelength.

6. The four-junction solar cell as defined in claim 3, 4 or 5, wherein the distributed Bragg reflector layer (114; 122c) includes a first distributed Bragg reflector layer composed of a plurality of p type AlₓGa₁₋ₓAs layers, 0 < x < 1, and a second distributed Bragg reflector layer disposed over the first DBR layer and composed of a plurality of p type Al_{y}Ga_{1-y}As layers, 0 < y < 1, where y is greater than x.

7. The four-junction solar cell as defined in any of the preceding claims, wherein the third subcell (C) includes quantum wells that are "strain balanced" by incorporating alternating lower band gap (or larger lattice constant) InGaAs and higher band gap (or smaller lattice constant) GaAsP layers so that the larger/smaller atomic lattices/layers of epitaxy balance the strain to keep the quantum well layers lattice matched to the substrate.

8. A method of manufacturing the four-junction solar cell as defined in claim 1, the method comprising:
providing a first substrate (101);
depositing on the first substrate a first sequence of layers of semiconductor material forming a first solar subcell (A), and a second solar subcell (B), and a third solar subcell (C),
depositing on said third solar subcell (C) a graded interlayer (124) composed of (InₓGa₁₋ₓ)_{y}Al_{1-y}As with 0 < x < 1, 0 < y < 1, and x and y selected such that the band gap remains constant at a value in a range of 1.42 - 1.6 eV throughout its thickness;
depositing on said graded interlayer (124) a second sequence of layers of semiconductor material forming a fourth solar subcell (D), the fourth solar subcell (D) being lattice mismatched to the third solar subcell (C);
mounting and bonding a surrogate substrate (131) on top of the sequence of layers; and removing the first substrate (101),
wherein the lower fourth solar subcell (D) has a band gap of approximately 1.10 eV, the third solar subcell (C) has a band gap in the range of 1.40 to 1.42 eV, the second solar subcell (B) has a band gap of approximately 1.73 eV and the upper first solar subcell (A) has a band gap of approximately 2.10 eV.

## Patentansprüche

1. Invertierte metamorphe Vierfach-Solarzelle, enthaltend:
eine obere erste Solar-Unterzelle (A), aufweisend eine erste Bandlücke, wobei die obere erste Solar-Unterzelle (A) aus einer AlInGaP- oder InGaP-Emitterschicht (106) und einer AlInGaP-Basisschicht (107) zusammengesetzt ist;
eine zweite Solar-Unterzelle (B), angrenzend zu besagter oberen ersten Solar-Unterzelle (A) und aufweisend eine zweite Bandlückee, die kleiner ist als besagte erste Bandlücke, wobei die zweite Unterzelle (B) aus einer InGaP-Emitterschicht (111) und einer AlGaAs-Basisschicht (112) zusammengesetzt ist;
eine dritte Solar-Unterzelle (C), angrenzend zu besagter zweiten Solar-Unterzelle (B) und aufweisend eine dritte Bandlücke, die kleiner ist als besagte zweite Bandlücke, wobei die dritte Solar-Unterzelle (C) aus GaAs oder InₓGa₁₋ₓAs (mit 0 < x < 0,01) zusammengesetzt ist;
eine abgestufte Zwischenschicht (124), angrenzend zu besagter dritten Solar-Unterzelle (C), wobei besagte abgestufte Zwischenschicht (124) eine vierte Bandlücke aufweist, die größer ist als besagte dritte Bandlücke; und
eine untere vierte Solar-Unterzelle (D), angrenzend zu besagter abgestuften Zwischenschicht (124), wobei besagte untere vierte Solar-Unterzelle (D) eine fünfte Bandlücke aufweist, die kleiner ist als besagte dritte Bandlücke, so dass besagte untere vierte Solar-Unterzelle (D) gitterfehl-angepasst in Bezug auf diese dritte Solar-Unterzelle ist, wobei die untere vierte Unterzelle (D) aus InGaAs zusammengesetzt ist;
wobei die abgestufte Zwischenschicht (124) kompositorisch zur Gitteranpassung an die dritte Solar-Unterzelle (C) auf der einen Seite und der unteren vierten Solar-Unterzelle (D) auf der anderen Seite abgestuft ist, und aus (InₓGa₁₋ₓ)_{y}Al_{1-y} mit 0< x < 1,0 < y < 1 zusammengesetzt ist und x und y so ausgewählt sind, dass die Bandlücke konstant bleibt bei einem Wert in einem Bereich von 1,42 - 1,6 eV durch ihre gesamte Dicke, vorbehaltlich der Einschränkungen, dass sie den Gitterparameter in der Ebene größer oder gleich dem der dritten Solar-Unterzelle (C) und kleiner oder gleich dem der unteren Solar-Vierten Unterzelle (D) aufweist;
wobei die untere vierte Solar-Unterzelle (D) eine Bandlücke von annähernd 1,10 eV aufweist, die dritte Solar-Unterzelle (C) eine Bandlücke im Bereich von 1,40 bis 1,42 eV aufweist, die zweite Solar-Unterzelle (B) eine Bandlücke von annähernd 1,73 eV aufweist und die obere erste Solar-Unterzelle (A) eine Bandlücke von annähernd 2,10 eV aufweist.

2. Vierfach-Solarzelle gemäß Anspruch 1, die ferner eine Alpha-Schicht (123), zusammengesetzt aus GaInP, angrenzend zur abgestuften Zwischenschicht (124) enthält, um zu verhindern, dass sich Threading-Dislokation ausbreiten, entweder entgegen der Wachstumsrichtung in die erste (A), zweite (B) oder dritte Unterzelle (C) oder in Wachstumsrichtung in die vierte Unterzelle (D).

3. Vierfach-Solarzelle gemäß einem der vorangehenden Ansprüche, ferner enthaltend:
eine Bragg-Spiegel- bzw. Distributed Bragg Reflector-Schicht (114), angrenzend zu und zwischen den zweiten (B) und dritten (C) Solar-Unterzellen und so angeordnet, dass Licht in die zweite Solar-Unterzelle (B) eintreten und durchgehen kann und mindestens ein Teil davon durch die Bragg-Spiegelschicht (114) in die zweite Solar-Unterzelle (B) zurückreflektiert werden kann..

4. Vierfach-Solarzelle gemäß einem der vorangehenden Ansprüche, ferner enthaltend:
eine Bragg-Spiegel- bzw. Distributed Bragg Reflector-Schicht (122c), angrenzend zu und zwischen der dritten Solar-Unterzelle (C) und der abgestuften Zwischenschicht (124) und so angeordnet, dass Licht in die dritte Solar-Unterzelle (C) eintreten und durchgehen kann und mindestens ein Teil davon durch die Bragg-Spiegelschicht (122c) in die dritte Solar-Unterzelle (C) zurückreflektiert werden kann.

5. Vierfach-Solarzelle gemäß Anspruch 4, wobei die Bragg-Spiegel- bzw. Distributed Bragg Reflector-Schicht (122c) aus einer Vielzahl von abwechselnden Schichten von gitterangepassten Materialien mit Diskontinuitäten in ihren jeweiligen Brechungsindizes zusammengesetzt ist, und die Differenz der Brechungsindizes zwischen wechselnden Schichten maximiert ist, um die Anzahl der Perioden zu minimieren, die erforderlich sind, um eine gegebene Reflektivität zu erreichen, und die Dicke und der Brechungsindex jeder Periode das Sperrband und seine begrenzende Wellenlänge bestimmt.

6. Vierfach-Solarzelle gemäß Anspruch 3, 4 oder 5, wobei die Bragg-Spiegel- bzw. Distributed Bragg Reflector-Schicht (114; 122c) eine erste Bragg-Spiegelschicht, zusammengesetzt aus einer Vielzahl von p-Typ AlₓGa₁₋ₓAs-Schichten, 0 < x < 1, und eine zweite Bragg-Spiegelschicht umfasst, die auf der ersten DBR-Schicht angeordnet ist und aus einer Vielzahl von p-Typ Al_{y}Ga_{1-y}As-Schichten, 0 < y < 1, zusammengesetzt ist, wobei y größer als x ist.

7. Vierfach-Solarzelle gemäß einem der vorangehenden Ansprüche, wobei die dritte Unterzelle (C) Quantentöpfe umfasst, die "Verspannungs-ausgeglichen" sind, in dem sie abwechselnde InGaAs-Schichten mit niedrigerer Bandlücke (oder größerer Gitterkonstante) und GaAsP-Schichten mit größerer Bandlücke (oder kleinerer Gitterkonstante) einschließt, so dass die größeren/kleineren Atomgitter/Epitaxie-Schichten die Verspannung ausgleichen, um die Quantentopf-Schichten gitterangepasst zu dem Substrat zu halten.

8. Verfahren zur Herstellung der Vierfach-Solarzelle gemäß Anspruch 1, wobei das Verfahren enthält:
Bereitstellen eines ersten Substrats (101);
Abscheiden auf dem ersten Substrat einer ersten Sequenz von Schichten aus Halbleitermaterial unter Bildung einer ersten Solar-Unterzelle (A) und einer zweiten Solar-Unterzelle (B) und einer dritten Solar-Unterzelle (C),
Abscheiden auf besagter dritten Solar-Unterzelle (C) eine abgestufte Zwischenschicht (124), zusammengesetzt aus (InₓGa₁-ₓ)_{y}Al_{1-y}As mit 0< x < 1, 0 < y < 1 und x und y so ausgewählt, dass die Bandlücke konstant bleibt bei einem Wert in einem Bereich von 1,42 - 1,6 eV durch ihre gesamte Dicke;
Abscheiden auf besagter abgestuften Zwischenschicht (124) eine zweite Sequenz von Schichten aus Halbleitermaterial unter Bildung einer vierten Solar-Unterzelle (D), wobei die vierte Solar-Unterzelle (D) an die dritte Solar-Unterzelle (C) gitterfehl-angepasst ist;
Montieren und Verbinden eines Ersatzsubstrats (131) auf der Sequenz der Schichten; und Entfernen des ersten Substrats (101),
wobei die untere vierte Solar-Unterzelle (D) eine Bandlücke von annähernd 1,10 eV aufweist, die dritte Solar-Unterzelle (C) eine Bandlücke im Bereich von 1,40 bis 1,42 eV aufweist, die zweite Solar-Unterzelle (B) eine Bandlücke von annähernd 1,73 eV aufweist und die obere erste Solar-Unterzelle (A) eine Bandlücke von etwa 2,10 eV aufweist.

## Revendications

1. Une cellule solaire métamorphique inversée à quatre jonctions comprenant :
une première sous-cellule solaire supérieure (A) ayant une première bande interdite, dans laquelle la première sous-cellule solaire supérieure (A) est composée d'une couche d'émetteur d'AlInGaP ou d' InGaP (106) et d'une couche de base d'AlInGaP (107);
une deuxième sous-cellule solaire (B) adjacente à ladite première sous-cellule solaire supérieure (A) et ayant une deuxième bande interdite plus petite que ladite première bande interdite, dans laquelle la deuxième sous-cellule (B) est composée d'une couche d'émetteur d'InGaP (111) et d'une couche de base d'AlGaAs (112);
une troisième sous-cellule solaire (C) adjacente à ladite deuxième sous-cellule solaire (B) et ayant une troisième bande interdite plus petite que ladite deuxième bande interdite, dans laquelle la troisième sous-cellule solaire (C) est composée de GaAs ou InₓGa₁₋ₓAs (avec 0 < x < 0,01);
une couche intermédiaire graduée (124) adjacente à ladite troisième sous-cellule solaire (C), la couche intermédiaire graduée (124) ayant une quatrième bande interdite plus grande que ladite troisième bande interdite; et
une quatrième sous-cellule solaire inférieure (D) adjacente à ladite couche intermédiaire graduée (124), ladite quatrième sous-cellule solaire inférieure (D) ayant une cinquième bande interdite plus petite que ladite troisième bande interdite telle que ladite quatrième sous-cellule solaire inférieure (D) a un réseau non-adapté par rapport à ladite troisième sous-cellule solaire, dans laquelle la quatrième sous-cellule inférieure (D) est composée d'InGaAs;
dans laquelle la couche intermédiaire graduée (124) est graduée en composition pour avoir un réseau adapté par rapport la troisième sous-cellule solaire (C) d'un côté et la quatrième sous-cellule solaire inférieure (D) de l'autre côté, et est composée de (InₓGa₁₋ₓ)_{y}Al_{1-y} avec 0 < x < 1,0 < y < 1, et x et y sélectionnés de telle sorte que la bande interdite reste constante à une valeur dans une gamme de 1,42 - 1,6 eV dans toute son épaisseur, sous réserve des contraintes d'avoir le paramètre de réseau en plan supérieur ou égal à celui de la troisième sous-cellule solaire (C) et inférieur ou égal à celui de la quatrième sous-cellule solaire inférieure (D);
dans laquelle la quatrième sous-cellule solaire inférieure (d) a une bande interdite d'environ 1,10 eV, la troisième sous-cellule solaire (C) a une bande interdite dans la gamme de 1,40 à 1,42 eV, la deuxième sous-cellule solaire (B) a une bande interdite d'environ 1,73 eV et la première sous-cellule solaire supérieure (A) a une bande interdite d'environ 2,10 eV.

2. La cellule solaire à quatre jonctions selon la revendication 1, comprenant en outre une couche alpha (123) composée de GaInP adjacente à la couche intermédiaire graduée (124) pour empêcher des dislocations de filetage de se propager, soit en face de la direction de croissance dans la première (A), deuxième (B) ou troisième sous-cellule (C) ou dans le sens de la croissance dans la quatrième sous-cellule (D).

3. La cellule solaire à quatre jonctions selon l'une des revendications précédentes, comprenant en outre :
une couche de réflecteur Bragg distribuée (114) adjacente à et entre la deuxième (B) et la troisième (C) sous-cellules solaires et disposée de sorte que la lumière puisse entrer et passer à travers la deuxième sous-cellule solaire (B) et dont au moins une partie peut être réfléchie dans la deuxième sous-cellule solaire (B) par la couche de réflecteur Bragg distribuée (114).

4. La cellule solaire à quatre jonctions selon l'une des revendications précédentes, comprenant en outre :
une couche réflecteur de Bragg distribuée (122c) adjacente à et entre la troisième sous-cellule solaire (C) et la couche intermédiaire graduée (124) et disposée de sorte que la lumière puisse entrer et passer à travers la troisième sous-cellule solaire (C) et dont au moins une partie peut être réfléchie dans la troisième sous-cellule solaire (C) par la couche réflecteur de Bragg distribuée (122c).

5. La cellule solaire à quatre jonctions selon la revendication 4, dans laquelle la couche réflecteur de Bragg distribuée (122c) est composée d'une pluralité de couches alternées en matériaux adaptés en réseaux, ayant des discontinuités dans leurs indices respectifs de réfraction, et la différence dans les indices de réfraction entre les couches alternées est maximisée afin de minimiser le nombre de périodes nécessaires pour atteindre une réflectivité donnée, et l'épaisseur et l'indice réfractif de chaque période détermine la bande d'arrêt et sa longueur d'onde limitative.

6. La cellule solaire à quatre jonctions selon la revendication 3, 4 ou 5, dans laquelle la couche réflecteur de Bragg distribuée (114; 122c) comprend une première couche réflecteur de Bragg distribuée composée d'une pluralité couches de type p d'AlₓGa₁₋ₓAs, 0 < x < 1, et une deuxième couche réflecteur de Bragg distribuée disposée sur la première couche de DBR et composée d'une pluralité de couches de type p d'Al_{y}Ga_{1-y}As, 0 < y < 1, dans laquelle y est plus grand que x.

7. La cellule solaire à quatre jonctions selon l'une des revendications précédentes, dans laquelle la troisième sous-cellule (C) comprend des puits quantiques qui sont « équilibrés en contrainte » en incorporant des couches alternées de bande interdite plus basse (ou constante de réseau plus grande) d'InGaAs et de bande interdite plus élevée (ou constante de réseau plus petite) de GaAsP de sorte que les réseaux atomiques/couches d'épitaxie plus grands/plus petits équilibrent la contrainte pour maintenir les couches de puits quantique afin d'avoir un réseau adapté au substrat.

8. Un procédé de fabrication d'une cellule solaire à quatre jonctions selon la revendication 1 comprenant :
fournir un premier substrat (101);
déposer sur le premier substrat une première séquence de couches en matériau semi-conducteur formant une première sous-cellule solaire (A), et une deuxième sous-cellule solaire (B), et une troisième sous-cellule solaire (C),
déposer sur ladite troisième sous-cellule solaire (C) une couche intermédiaire graduée (124) composée de (InₓGa₁₋ₓ)yAl_{1-y}As avec 0 < x < 1,0 < y < 1, et x et y sélectionnés de telle sorte que la bande interdite reste constant à une valeur dans une gamme de 1,42 - 1.6 eV dans toute son épaisseur;
déposer sur ladite couche intermédiaire graduée (124) une deuxième séquence de couches de matériau semi-conducteur formant une quatrième sous-cellule solaire (D), la quatrième sous-cellule solaire (D) ayant un réseau non-adapté à la troisième sous-cellule solaire (C);
monter et coller un substrat de substitution (131) au-dessus de la séquence des couches; et enlever le premier substrat (101),
dans lequel la quatrième sous-cellule solaire inférieure (d) a une bande interdite d'environ 1,10 eV, la troisième sous-cellule solaire (C) a une bande interdite dans la gamme de 1,40 à 1,42 eV, la deuxième sous-cellule solaire (B) a une bande interdite d'environ 1,73 eV et la première sous-cellule solaire supérieure (A) a une bande interdite d'environ 2,10 eV.
